# EUROPÄISCHE PATENTSCHRIFT

(11) **EP 0 867 946 B1**
(45) Veröffentlichungstag und Bekanntmachung des Hinweises auf die Patenterteilung: **15.10.2008**
(21) Anmeldenummer: 98105508.0
(22) Anmeldetag: 26.03.1998
(51) Int. Cl.: H01L 31/05, H01L 31/048

(54) **Photovoltaisches Solarmodul in Plattenform**
Photovoltaic solar module in a plate form
Module solaire photovoltaique en forme de plaque

(30) Priorität: 26.03.1997 DE 19712747
(43) Veröffentlichungstag der Anmeldung: 30.09.1998
(73) Patentinhaber: Scheuten Solar Technology GmbH, 45884 Gelsenkirchen (DE)
(72) Erfinder: Wambach, Karsten, Dr., 40885 Ratingen (DE)
(74) Vertreter: Jostarndt, Hans-Dieter

(56) Entgegenhaltungen:
- EP-A- 0 680 097
- DE-U- 29 605 510
- US-A- 4 167 644
- US-A- 4 401 839
- US-A- 5 110 369

## Beschreibung

Die Erfindung betrifft ein photovoltaisches Solarmodul in Plattenform, insbesondere zur Verwendung als Fassaden- oder Dachelement, mit wenigstens einer dem einfallenden Licht zugewandten Außenscheibe, wenigstens einer in Lichteinfallrichtung dahinter unter Erzeugung eines Scheibenzwischenraumes mit Abstand angeordneten Innenabdeckung und gegebenenfalls einem die Außenscheibe und die Innenabdekkung umlaufend dicht miteinander verbindenden Randaufbau und mit zwischen der Außenscheibe und der Innenabdeckung angeordneten, in Gießharz, Verbundfolie(n) oder dergleichen eingebetteten Solarzellen mit einem diese elektrisch verschaltenden Leitersystem, von dem Anschlußleitungen zum elektrischen Verbinden mit benachbarten weiteren Solarmodulen in den außerhalb des Plattenaufbaus liegenden Bereich führen. Die Anschlußleitungen sind dabei an einer Anschlußfahne befestigt, welche mit einem sich im Wesentlichen außerhalb und am Rand des Plattenaufbaus erstreckenden Modulanschlußelement verbunden ist, wobei das Modulanschlußelement einen im Wesentlichen zylinderförmigen Grundkörper aufweist, und das Modulanschlußelement ferner Hülsen, Stecker oder Buchsen umfasst und mit entsprechenden Modulanschlußelementen benachbarter Solarmodule verschaltbar ist.

Solarmodule dieser Art werden in der Regel unter mechanischer und elektrischer Verbindung zu Solar-Fassadenflächen oder Solar-Dacheindeckungen zusammengesetzt. Es werden dabei die elektrischen Kontaktflächen durch entsprechende elektrische Verbindungsstücke miteinander verbunden; getrennt hiervon ist die mechanische Verbindung benachbarter Solarmodule vorzunehmen.

Bei den in der DE 41 40 682 A1 beschriebenen Solarmodulen ist ein elektrisches Kontaktstiftsystem in einem den Plattenaufbau umgebenden Rahmen vorgesehen, wobei der Rahmen mit einem in mechanischer als auch in elektrischer Hinsicht komplementär ausgebildetem Rahmen eines benachbarten Solarmoduls in Eingriff zu bringen ist.

Die WO 93/12636 trägt den Anforderungen von Solarmodul-Plattenaufbauten im Schiffbaubereich Rechnung und schlägt vor, ein Anschlußgehäuse zum Abschirmen der Verbindung eines elektrischen Kabels mit den Anschlußleitungen eines Solarmoduls nahe einem Kantenbereich des Plattenaufbaus zu verwenden, wobei die Kabelanschlüsse mit beispielsweise Epoxyharz vergossen werden, um Feuchtigkeit von den kritischen Bereichen der elektrischen Anlage fernzuhalten.

Bei anderen Arten von Verbundglasscheiben hat es sich als zweckmäßig erwiesen, die Anschlußleitungen beispielsweise von Heizdrähten an eine Anschlußfahne zu führen, welche zu einer Kabelanschlußhülle aufgerollt ist, in die Kabel gelötet sind. Eine solche Anordnung ist beispielsweise in der DE 90 16 664 U1 oder in der EP 0 619 691 A1 offenbart. Eine ähnliche Anordnung für ein Antennen-Anschlußstück zeigt die US 5 268 700. Eine Anordnung, bei der Heizleiter an mehreren Hülsen mit Anschlußfahne herausgeführt werden, ist in der DE 42 06 365 C1 dargestellt.

Grundsätzlich würde ein derartiges Herausführen der elektrischen Anschlußleitungen über eine Anschlußfahne eine kostengünstige Alternative zu der in der DE 41 40 682 A1 vorgeschlagenen Lösung sein. Allerdings müßte in Kauf genommen werden, daß die elektrische Verschaltung der verschiedenen Solarmodule von einem Elektrofachmann vorgenommen wird, da eine eindeutige Zuordnung der lose abhängenden elektrischen Anschlußleitungen, die wesentlich komplexere Anschlußmöglichkeiten fordert, als beispielsweise bei einer Heizscheibe, dem üblicherweise mit der Installation von photovoltaischen Solar-Eindeckungen befaßten Baupersonal nicht überlassen werden kann. Die DE 296 05 510 U1 schlägt dazu ein photovoltaisches Solarmodul vor, dessen Anschlußsystem eine Hülse mit Stecker- und Buchsensystem zum Verschalten benachbarter Module aufweist, wobei der elektrische Kontakt durch eine in den Scheibenzwischenraum ragenden Anschlußfahne vermittelt wird, die in der Symmetrieebene der Hülse angeordnet ist. Die Hülse kann sich dabei an beiden Scheiben des Plattenaufbaus abstützen.

Diese bekannte Anordnung ist für spezielle Solarmodulausführungen verbesserungsbedürftig, zum Beispiel, wenn eine der den Plattenaufbau bildenden Komponenten, in der Regel die rückseitige Innenabdeckung, als mechanisch nicht oder nur wenig tragendes Teil, beispielsweise als flexible Folie, ausgebildet ist.

Die US 4 167 644 offenbart ein Solarmodul mit einer Anschlussdose, die mit einer Oberfläche des Solarmoduls verbunden ist. Die Anschlussdose befindet sich dabei innerhalb des Solarmoduls. Die einzelnen Solarzellen sind miteinander verbunden und die Verbindungskabel münden in die Anschlussdose. Aus der Anschlussdose wird ein Anschlusskabel aus dem Solarmodul hinausgeführt, indem das Kabel durch einen Halter geführt wird, an den ein Steckanschluss angeschlossen werden kann.

Ferner beschreibt die US 5 110 369 eine Vorrichtung zum Verbinden von Solarzellen, die eine leitende, von der Rückwand hervorstehende und mit einem Loch versehene Anschlussfahne umfasst. Ein isolierender konvex/konkaver Körper, der ebenfalls eine Öffnung aufweist, ist mit der Rückwand verbunden. Der Körper ist so positioniert, dass das Loch in der Anschlussfahne sich gegenüber der Öffnung in besagtem Körper befindet. Die Anschlussfahne wird zwischen einer Schraubenmutter und dem Körper eingeklemmt. Eine Schraube dient dazu, den isolierenden Körper mit einem zweiten Köper, an dem Kabel abringbar sind, zu verbinden und so den elektrischen Kontakt zwischen den Kabeln und der Anschlussfahne herzustellen. Der isolierende Körper kann dabei mit der Innenscheibe verklebt sein.

Aus der US 4 401 839 ist ein Solarmodul mit wenigstens einer Solarzelle bekannt, das eine Folie aus gehärtetem Aluminium aufweist, die an der Unterseite der Solarzelle angebracht ist. Durch die Aluminiumfolie kann die Stabilität des Solarmoduls erhöht werden, ohne dass die Dicke maßgeblich erhöht werden muss.

Es ist die Aufgabe der Erfindung, ein Solarmodul der eingangs genannten Art zur Verfügung zu stellen, dessen elektrisches Anschlußsystem eine hohe mechanische Stabilität aufweist, auch wenn einzelne Komponenten mechanisch weniger belastbar sind, wobei das Anschlußsystem so ausgebildet sein soll, dass es sich bei ein und derselben Ausgestaltung sowohl am Modulrand als auch an den Außenflächen des Plattenaufbaus anordnen und mit diesem verkleben lässt.

Diese Aufgabe wird von einem Solarmodul nach Anspruch 1 gelöst. Vorteilhafte Ausgestaltungen sind Gegenstand der Unteransprüche.

Erfindungsgemäß ist vorgesehen, daß die Anschlußleitungen an einer Anschlußfahne befestigt sind, welche mit einem sich im wesentlichen außerhalb des Plattenaufbaus erstreckenden Modulanschlußelement verbunden ist, wobei die Anschlußfahne in einer Tangentialebene des Modulanschlußelements angeordnet ist und wobei das Modulanschlußelement mit entsprechenden Modulanschlußelementen benachbarter Solarmodule verschaltbar ist.

"In einer Tangentialebene des Modulanschlußelementes angeordnet" bedeutet dabei für die Anschlußfahne, daß diese tangential an einen den Querschnitt des Modulanschlußelementes umschreibenden, gedachten Kreis geführt ist und in einem Umfangspunkt des Modulanschlußelementes mündet - wie es bei einem kreisförmigen Querschnitt des Modulanschlußelementes ohnehin der Fall ist, aber beispielsweise auch bei einem höher-polygonalen Querschnitt des Modulanschlußelementes denkbar ist - oder daß diese tangential an oder in eine Seitenfläche des Modulanschlußelementes geführt ist, wie es beispielsweise bei einem Modulanschlußelement mit quadratischem Querschnitt zweckmäßig ist.

Erfindungsgemäß ist die Innenabdeckung eine flexible Folie oder ein flexibler Folienverbund, und die Anschlußfahne mündet tangential in die Außenfläche des zylinderförmigen Grundkörper, wobei senkrecht zur Anschlußfahne am Modulanschlusselement eine Anlagefläche vorgesehen ist, die ebenfalls tangential in die Außenfläche des Modulanschlußelementes einmündet und die Anschlussfahne zusammen mit der Außenfläche des zylinderförmigen Grundkörpers eine weitere Anlagefläche bildet, wobei das Modulanschlußelement mit einer Anlagefläche auf dem Umfangsrand der Außenscheibe oder auf einer dem Scheibenzwischenraum des Plattenaufbaus zugewandten Seite der Außenscheibe aufliegt.

Mit der Erfindung wird ein Anschlußsystem geschaffen, das sich auf besonders einfache und dennoch stabile Weise mit dem Solarmodul-Plattenaufbau mechanisch befestigen lässt. Das universelle Modulanschlußelement, das Stecker, Buchsen, Hülsen oder dergleichen umfasst, lässt sich bei ein und derselben Ausgestaltung sowohl am Modulrand als auch an den Außenflächen des Plattenaufbaus anordnen und mit diesen verkleben.

Die Erfindung weist dabei als Innenabdeckung eine flexible Folie, beispielsweise eine Kunststoff-Folie, bevorzugt aus Polyvinylidenfluorid, oder einen flexiblen Folienverbund auf. Der Folienverbund kann dabei ein Sandwich-Aufbau mit einer zumindest einseitig, in der Regel aber beidseitig kaschierten Basisfolie sein, die beispielsweise aus einem Kunststoff, wie Polyester, oder einem Metall, wie Aluminium, besteht. Die Kaschierung kann ein Fluoropolymer sein.

Um die mechanische Stabilität zu verbessern, kann auf der Folie zumindest im Bereich der Anschlußfahne eine Versteifungsplatte befestigt sein.

Um gleichzeitig das Modulanschlußelement zu schützen, kann vorgesehen sein, daß die Versteifungsplatte einen über den Randbereich des Plattenaufbaus ragenden Steg aufweist.

Besondere Vorteile entwickelt die Erfindung, wenn die Innenabdeckung eine flexible Kunststoff-Folie, ein flexibler Folienverbund oder eine dünne Glasscheibe ist, bei der der elektrische Anschluß gegen mechanische Störungen anfälliger ist als bei einer eigensteifen Platte bzw. Scheibe. "Dünn" meint in diesem Zusammenhang bei einer Glasscheibe eine Dicke von nicht mehr als 3mm.

Erfindungsgemäß wird eine Übergangsfläche vom zylindrischen Modulanschlußelement zur Anschlußfahne so gestaltet, daß diese Übergangsfläche senkrecht zur Anschlußfahne in einer weiteren Tangentialebene des Modulanschlußelementes verläuft und so eine weitere stabilisierende Fläche des Modulanschlußelementes bildet.

Es kann vorgesehen sein, daß die Anschlußfahne zumindest teilweise in den Scheibenzwischenraum ragt.

Das Modulanschlußelement ist am Rand des Plattenaufbaus angeordnet.

Das Modulanschlußelement kann in einer ersten Variante auf dem Umfangsrand der Außenscheibe aufliegen, vorzugsweise ist der Auflagebereich gegenüber dem der gegenüberliegenden Außenscheibe oder dem der Innenabdeckung mindestens bereichsweise zurückversetzt ausgeführt. Dadurch kann das Modulanschlußelement besonders platzsparend am Rand des Solarmoduls angeordnet, ein Überstehen wird vermieden. In einer zweiten Variante kann es auf einer dem Scheibenzwischenraum des Plattenaufbaus zugewandten Seite der Außenscheibe oder der Innenabdeckung aufsitzen. Auch Kombinationen beider Varianten sind denkbar.

Schließlich kann das Modulanschlußelement einen im wesentlichen kreisförmigen oder polygonalen Querschnitt aufweisen.

Im folgenden soll die Erfindung anhand der beigefügten Zeichnung näher erläutert werden. Es zeigt:
- Figur 1: ein Ausführungsbeispiel eines universellen Modulanschlußelementes mit Anschlußfahne im Querschnitt;
- Figur 2: eine Querschnittsansicht eines Solarmodul-Plattenaufbaus mit Modulanschlußelement;
- Figur 3: einen weiteren Solarmodul-Plattenaufbau mit Modulanschlußelement;
- Figur 4: einen Solarmodul-Plattenaufbau mit einer Folie als Innenabdeckung, bei dem das Modulanschlußelement am Umfangsrand als Außenscheibe anliegt; und
- Figur 5: eine Draufsicht auf einen Plattenaufbau im Bereich des elektrischen Anschlußsystems.

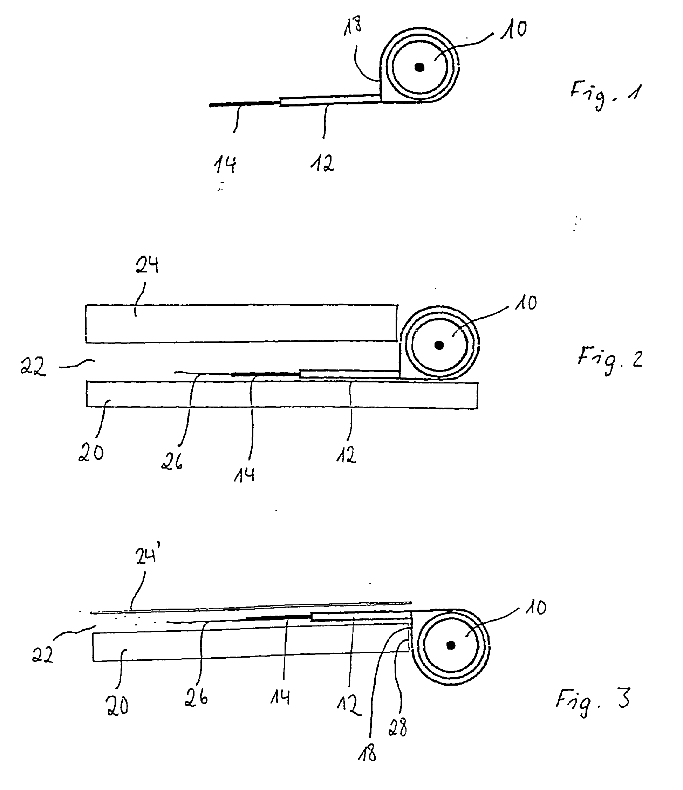

Figur 1 zeigt ein universelles Modulanschlußelement 10, das einen im wesentlichen zylinderförmigen Grundkörper aufweist, in den tangential eine Anschlußfahne 12 mündet, an deren distalem Ende elektrische Anschlüsse 14 vorgesehen sind. Senkrecht zur Anschlußfahne 12 ist eine Anlagefläche 18 vorgesehen, die ebenfalls tangential in die Außenfläche des Modulanschlußelementes 10 einmündet.

Figur 2 zeigt ein Beispiel eines Solarmodul-Plattenaufbaus, der aus einer transparenten Außenscheibe 20 besteht, die der Lichteinfallseite zugewandt ist. Die Außenscheibe 20 kann aus Kunststoff oder Glas bestehen, vorzugsweise aus einem hochtransparenten Kalknatronsilikatglas, wie Weißglas. Beabstandet von der Außenscheibe 20 ist eine Innenabdeckung 24 angeordnet, hier eine eigensteife Platte, beispielsweise eine Glasscheibe, wobei die Außenscheibe 20 und die Platte 24 einen Scheibenzwischenraum 22 definieren, in dem sich die Solarzellen befinden, beispielsweise eingebettet in eine Kunststoffschicht aus Polyvinylbutyral (PVB) oder Ethylenvinylacetat (EVA). Die Solarzellen sind in der Zeichnung weggelassen; mit der Bezugsziffer 26 sind lediglich die von ihnen abführenden elektrischen Leitungen angedeutet, die mit den Anschlüssen 14 zu verbinden sind. Bei der in Figur 2 dargestellten Ausführungsform ragt die Anschlußfahne 12 mit den Anschlüssen 14 in den Scheibenzwischenraum 22, während das Modulanschlußelement 10 auf der dem Scheibenzwischenraum 22 zugewandten Seite der Außenscheibe aufsitzt und sich innerhalb einer Stufe erstreckt, die durch die entsprechend zurücktretende Kante der Platte 24 gebildet wird. Da die Anschlußfahne 12 tangential in die Umfangsfläche des Modulanschlußelementes 10 übergeht, kann durch eine geeignete Klebefixierung ein fester mechanischer Halt zwischen Anschlußfahne 12 bzw. Modulanschlußelement 10 und Außenscheibe 20 bewirkt werden.

Bei der in Figur 3 dargestellten Ausführungsform ist der Scheibenzwischenraum 22 zwischen einer Außenscheibe 20 und einer Folie 24' gebildet. Da die Folie 24' mechanisch nur wenig belastbar ist, ist das Modulanschlußelement 10 so angeordnet, daß seine Anlagefläche 18 auf dem Umfangsrand 28 der Außenscheibe 20 aufsitzt.

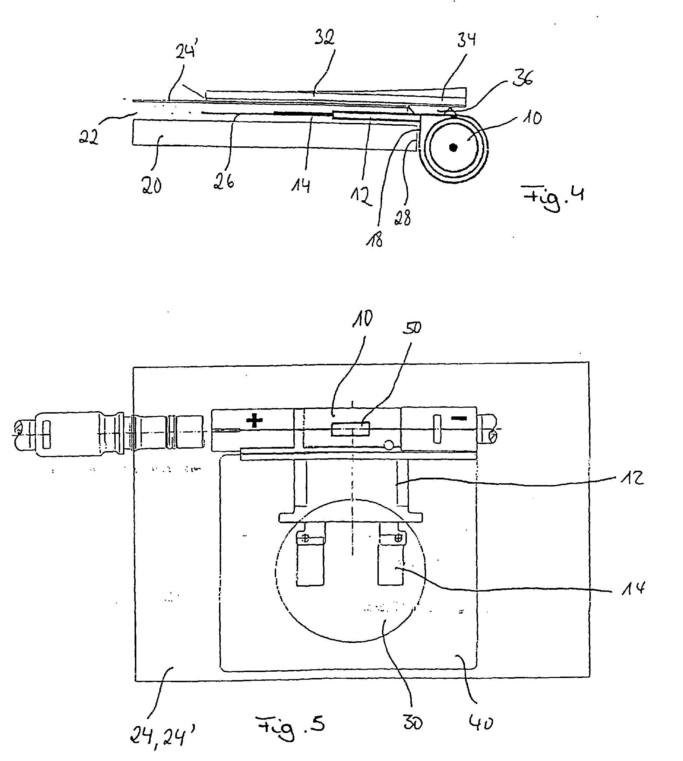

Um die mechanische Stabilität der Anordnung weiter zu verbessern, ist, wie in Figur 4 dargestellt, der Bereich der Folie 24', der über den Anschlußleitungen 14 bzw. der Anschlußfahne 12 liegt, mit einer Verstärkungsplatte 32 abgedeckt. Diese Verstärkungsplatte 32 weist bei der vorliegenden Ausführungsform einen sie verlängernden Steg 34 auf, der sich zumindest teilweise über das Modulanschlußelement 10 erstreckt und mit diesem durch Verkleben, beispielsweise mit einem hochfesten Kleber oder einem Klebeband 36, befestigt ist.

Anstelle der Folie 24' kann auch ein Folienverbund vorgesehen sein. Dieser besteht beispielsweise aus einer etwa 400 µm starken Polyester- oder Aluminiumfolie, die beidseitig mit einer Folie aus einem Fluoropolymer, jeweils etwa 20 µm stark, kaschiert ist.

Ein weiterer bevorzugter Folienverbund besteht aus 27 µm starker Folie aus Polyvinylidenfluorid (PVF), 75 µm starker Folie aus Polyethylenterephthalat (PETP) und 37 µm starker Folie aus Polyvinylidenfluorid (PVF). Ebenfalls bevorzugt ist ein Verbund aus 37 µm starker Folie aus Polyvinylidenfluorid (PVF), 50 µm starker Folie aus Polyethylenterephthalat (PETP), 30 µm starker Aluminiumfolie (Al) und 37 µm starker Folie aus Polyvinylidenfluorid (PVF).

Figur 5 zeigt eine Draufsicht auf den Bereich der elektrischen Anschlüsse eines Solarmoduls ähnlich dem, wie es in Figur 4 dargestellt ist. Das Modulanschlußelement 10 ist rückseitig im Randbereich des Plattenaufbaus auf der Innenabdeckung 24, 24' angeordnet und enthält eine Diode 50, welche die Anschlußleitungen überbrückt und somit bei einem elektrischen Defekt innerhalb des Moduls einen Bypass bildet. In der Innenabdeckung 24, 24' ist eine Durchgangsöffnung 30 vorgesehen, über die die Anschlußfahne 12 bzw. zumindest ihre Anschlüsse 14 zu liegen kommen. Der Bereich der Durchgangsöffnung 30 ist von einer Schutzkappe 40 bedeckt.

Die Durchgangsöffnung 30 kann in die Glasplatte gebohrt werden, bei der Verwendung von Folien kann gestanzt oder geschnitten werden. Insbesondere bei Folien ist eine Ausbildung als Schlitz möglich, durch den die Anschlußleitungen geführt werden.

## Patentansprüche

1. Solarmodul in Plattenform, insbesondere zur Verwendung als Fassaden- oder Dachelement, mit wenigstens einer dem einfallenden Licht zugewandten Außenscheibe (20), wenigstens einer in Lichteinfallsrichtung dahinter unter Erzeugung eines Scheibenzwischenraumes mit Abstand angeordneten Innenabdeckung (24,24') und mit zwischen der Außenscheibe (20) und der Innenabdeckung (24,24') angeordneten, in Gießharz oder Verbundfolie(n) eingebetteten Solarzellen mit einem diese elektrisch verschaltenden Leitersystem, von dem Anschlußleitungen (26) zum elektrischen Verbinden mit benachbarten weiteren Solarmodulen in den außerhalb des Plattenaufbaus liegenden Bereich führen, wobei die Anschlußleitungen (26) an einer Anschlußfahne (12) befestigt sind, welche mit einem sich im Wesentlichen außerhalb und am Rand des Plattenaufbaus erstreckenden Modulanschlußelement (10) verbunden ist, wobei das Modulanschlußelement (10) einen im Wesentlichen zylinderförmigen Grundkörper aufweist, und das Modulanschlußelement (10) ferner Hülsen, Stecker oder Buchsen umfasst und mit entsprechenden Modulanschlußelementen benachbarter Solarmodule verschaltbar ist,
**dadurch gekennzeichnet,**
**dass** die Innenabdeckung (24, 24') eine flexible Folie (24') oder ein flexibler Folienverbund ist, und die Anschlußfahne (12) tangential in die Außenfläche des zylinderförmigen Grundkörpers mündet, wobei senkrecht zur Anschlußfahne (12) am Modulanschlusselement eine Anlagefläche (18) vorgesehen ist, die ebenfalls tangential in die Außenfläche des Modulanschlußelementes (10) einmündet und die Anschlussfahne zusammen mit der Außenfläche des zylinderförmigen Grundkörpers eine weitere Anlagefläche
bildet, wobei das Modulanschlußelement (10) mit einer Anlagefläche auf dem Umfangsrand (28) der Außenscheibe (20) oder auf einer dem Scheibenzwischenraum (22) des Plattenaufbaus zugewandten Seite der Außenscheibe (20) aufliegt.

2. Solarmodul nach Anspruch 1,
**dadurch gekennzeichnet,**
**dass** der Folienverbund der Innenabdeckung (24, 24') ein Sandwich-Aufbau mit einer zumindest einseitig kaschierten Basisfolie ist, die beispielsweise aus Kunststoff, wie Polyester, oder Metall, wie Aluminium, besteht.

3. Solarmodul nach Anspruch 2,
**dadurch gekennzeichnet,**
**dass** die Basisfolie mit einem Fluoropolymer kaschiert ist.

4. Solarmodul nach Anspruch 1,
**dadurch gekennzeichnet,**
**dass** auf der Folie (24') oder dem Folienverbund zumindest im Bereich der Anschlußfahne (12) eine Versteifungsplatte (32) befestigt ist.

5. Solarmodul nach Anspruch 4,
**dadurch gekennzeichnet,**
**dass** die Versteifungsplatte (32) einen über den Randbereich des Plattenaufbaus ragenden Steg (34) aufweist.

6. Solarmodul nach einem der Ansprüche 1 bis 5,
**dadurch gekennzeichnet,**
**dass** die Anschlußfahne (12) zumindest teilweise in den Scheibenzwischenraum (22) ragt.

## Claims

1. A solar module in panel form, particularly for use as a façade element or roof element, comprising at least one outer pane (20) facing the incident light, at least one inner cover (24, 24') that is located behind it in the direction of the incident light and that creates a pane interstice at a certain distance, and comprising solar cells that are arranged between the outer pane (20) and the inner cover (24, 24'), that are embedded in cast resin or composite film(s) and that have a conductor system that electrically connects them, from which connection lines (26) for creating an electric connection to other adjacent solar cells lead to the area located outside of the panel structure, whereby the connection lines (26) are attached to a connection tab (12) that is connected to a module connection element (10) that extends essentially outside and at the edge of the panel structure, whereby the module connection element (10) has an essentially cylindrical base and the module connection element (10) also comprises sleeves, plugs or sockets and it can be connected with corresponding module connection elements of adjacent solar modules,
**characterized in that**
the inner cover (24, 24') is a flexible film (24') or a flexible film composite, and the connection tab (12) opens tangentially into the outer surface of the cylindrical base, whereby a contact surface (18) is provided on the module connection element perpendicular to the connection tab (12), said contact surface (18) likewise opening into the outer surface of the module connection element (10), and the connection tab, together with the outer surface of the cylindrical base, forms another contact surface, whereby one contact surface of the module connection element (10) lies on the circumferential edge (28) of the outer pane (20) or on a side of the outer pane (20) facing the pane interstice (22) of the panel structure.

2. The solar module according to Claim 1,
**characterized in that**
the film composite of the inner cover (24, 24') is a sandwich structure with a base film that is laminated at least on one side and that is made, for example, of a plastic such as polyester, or of a metal such as aluminum.

3. The solar module according to Claim 2,
**characterized in that**
the base film is laminated with a fluoropolymer.

4. The solar module according to Claim 1,
**characterized in that**
a stiffening panel (32) is attached to the film (24') or to the film composite, at least in the area of the connection tab (12).

5. The solar module according to Claim 4,
**characterized in that**
the stiffening panel (32) has a web (34) that protrudes beyond the edge area of the panel structure.

6. The solar module according to any of Claims 1 to 5,
**characterized in that**
the connection tab (12) protrudes at least partially into the pane interstice (22).

## Revendications

1. Module solaire sous forme de plaque, en particulier destiné à être utilisé comme élément de façade ou de toit, comprenant au moins une plaque extérieure (20) tournée vers la lumière incidente, au moins une plaque de revêtement intérieure (24, 24') située à distance de et derrière celle-ci dans le sens de la lumière incidente avec création d'un espace entre les plaques, et avec des cellules solaires situées entre la plaque extérieure (20) et la plaque de revêtement intérieure (24, 24') et enrobées dans de la résine coulée ou une ou des feuilles composites, avec un système de conducteurs qui relie lesdites cellules solaires par connexion électrique et dont des lignes de raccordement (26) vont à la zone située en dehors de la structure de plaques pour établir une liaison électrique avec d'autres modules solaires voisins, les lignes de raccordement (26) étant fixées à une languette de raccordement (12) qui est reliée à un élément de raccordement de module (10) qui s'étend sensiblement en dehors et sur le bord de la structure de plaques, l'élément de raccordement de module (10) présentant un corps de base sensiblement cylindrique et l'élément de raccordement de module comprenant en outre des manchons, des fiches ou des prises femelles et pouvant être connecté à des éléments de raccordement de module correspondants de modules solaires voisins, **caractérisé en ce que** la plaque de revêtement intérieure (24, 24') est une feuille flexible (24') ou un ensemble de feuilles flexible et la languette de raccordement (12) débouche tangentiellement dans la surface extérieure du corps de base cylindrique, une surface d'appui (18) étant prévue, perpendiculairement par rapport à la languette de raccordement (12), sur l'élément de raccordement de module, laquelle débouche également tangentiellement dans la surface extérieure de l'élément de raccordement de module (10), et la languette de raccordement constituant, conjointement avec la surface extérieure du corps de base cylindrique, une autre surface d'appui, l'élément de raccordement de module (10) s'appliquant avec une surface d'appui sur le bord périphérique (28) de la plaque extérieure (20) ou sur un côté de la plaque extérieure (20) tourné vers l'espace (22) compris entre les plaques de la structure de plaques.

2. Module solaire selon la revendication 1, **caractérisé en ce que** l'ensemble de feuilles de la plaque de revêtement intérieure (24, 24') est une structure en sandwich avec une feuille de base doublée sur au moins un côté, laquelle se compose, par exemple, de matière plastique telle que du polyester ou de métal tel que de l'aluminium.

3. Module solaire selon la revendication 2, **caractérisé en ce que** la feuille de base est doublée d'un fluoropolymère.

4. Module solaire selon la revendication 1, **caractérisé en ce qu'**une plaque de renforcement (32) est fixée sur la feuille (24') ou l'ensemble de feuilles au moins dans la zone de la languette de raccordement (12).

5. Module solaire selon la revendication 4, **caractérisé en ce que** la plaque de renforcement (32) présente une traverse (34) en saillie sur la zone de bord de la structure de plaques.

6. Module solaire selon l'une des revendications 1 à 5, **caractérisé en ce que** la languette de raccordement (12) fait saillie au moins en partie dans l'espace (22) compris entre les plaques.
